Europäisches Patentamt

European Patent Office

Office européen des brevets

(19)

(11) Veröffentlichungsnummer: **0 156 022**
**B1**

(12)

# EUROPÄISCHE PATENTSCHRIFT

(45) Veröffentlichungstag der Patentschrift:
**31.05.89**

(51) Int. Cl.⁴: **H 01 L 29/74, H 01 L 29/10**

(21) Anmeldenummer: **84115616.9**

(22) Anmeldetag: **17.12.84**

(54) **Durch Feldeffekt steuerbares Halbleiterbauelement.**

(30) Priorität: **30.03.84  DE 3411901**

(43) Veröffentlichungstag der Anmeldung:
**02.10.85 Patentblatt 85/40**

(45) Bekanntmachung des Hinweises auf die Patenterteilung:
**31.05.89 Patentblatt 89/22**

(84) Benannte Vertragsstaaten:
**DE FR GB IT**

(56) Entgegenhaltungen:
**EP-A-0 008 008**
**DE-A-2 802 727**
**DE-C-1 514 520**

(73) Patentinhaber: **Siemens Aktiengesellschaft Berlin und München, Wittelsbacherplatz 2, D-8000 München 2 (DE)**

(72) Erfinder: **Tihanyi, Jenö, Dr., Windeckstrasse 1d, D-8000 München 70 (DE)**

2

**Beschreibung**

Die vorliegende Erfindung bezieht sich auf ein durch Feldeffekt steuerbares Halbleiterbauelement mit einem Halbleiterkörper mit den Merkmalen:

a) Der Halbleiterkörper enthält eine Drainzone vom ersten Leitungstyp,

b) die Drainzone grenzt an eine der Oberflächen des Halbleiterkörpers, die zumindest teilweise mit einer Isolierschicht bedeckt ist,

c) in die Drainzone ist eine Kanalzone vom zueiten Leitungstyp planar eingebettet,

d) in die Kanalzone ist eine Sourcezone vom erste Leitungstyp planar eingebettet,

e) die Kanalzone und die Sourcezone sind durch einen Nebenschluß elektrisch miteinander verbunden,

f) an der anderen Oberfläche des Halbleiterkörpers ist eine am die Drainzone gewende vierte Zone vom zueiten Leitungstyp vorgesehen,

g) die Drainzone ist schwach dotiert im Vergleich zu den anderen Zonen,

h) auf der Isolierschicht ist eine Gateelektrode angeordnet, die den an die Oberfläche des Halbleiterkörpers tretenden Teil der Kanalzone überdeckt.

Ein solches Halbleiterbauelement ist beispielsweise in der Zeitschrift "Elektronikpraxis", Nr. 6, Juni 1983, Seiten 8 bis 12 beschrieben worden. Dieses Halbleiterbauelement hat eine Struktur wie ein durch Feldeffekt steuerbarer Thyristor. Die Stromverstärkung einer seiner beiden Teiltransistoren ist jedoch durch den Nebenschluß zwischen Sourcezone und Kanalzone so stark herabgesetzt, daß das Bauelement in weiten Bereichen als Transistor arbeitet. Es hat im Vergleich zu dreischichtigen MOS-FET einen bedeutend geringeren Durchlaßwiderstand $R_{on}$. Nachteilig macht sich die diesem Bauelement eigene Ausschaltverzögerung bemerkbar. Diese rührt daher, daß die aus der vierten Zone in die Mittelzone injizierten Ladungsträger ausgeräumt werden müssen, wenn das Bauelement Sperrspannung aufnimmt.

Der Erfindung liegt die Aufgabe zugrunde, ein Halbleiterbauelement der erwähnten Gattung derart weiterzubilden, daß die Ausschaltverzögerung stark herabgesetzt ist. Diese Aufgabe wird durch die folgenden Merkmale gelöst:

i) . der Abstand zwischen Kanalzone und vierter Zone ist mindestens doppelt so groß wie die Diffusionslänge der Minoritätsladungsträger in der Drainzone und

k) der Abstand zwischen Kanalzone und vierter Zone genügt der Bedingung:

$$a \geqslant 2\,\varepsilon_0\,\varepsilon_r\,\mu\,E_k\,\rho$$

wenn $\varepsilon_0$ die absolute Dielektrizitätskonstante, $\varepsilon_r$ die relative Dielektrizitätskonstante des Halbleitermaterials, $\mu$ die Beweglichkeit der Majoritätsladungsträger in der ersten Zone, $E_k$ die kritische elektrische Feldstärke des Halbleitermaterials ist und $\rho$ der spezifische Widerstand der Drainzone ist.

Weiterbildungen und eine Verwendung der Erfindung sind Gegenstand der Unteransprüche.

Die Erfindung wird anhand eines Ausführungsbeispieles in Verbindung mit den Figuren 1 bis 4 näher erläutert.

Es zeigen:

Fig. 1 den Schnitt durch ein Halbleiterbauelement nach dem Stand der Technik,

Fig. 2 den Schnitt durch ein Halbleiterbauelement nach der Erfindung,

Fig. 3 den Verlauf der Drainspannung über der Zeit beim Ein- und Ausschalten eines Halbleiterbauelements nach dem Stand der Technik und

Fig. 4 den Verlauf der Drainspannung über der Zeit beim Ein- und Ausschalten eines Halbleiterbauelements nach der Erfindung.

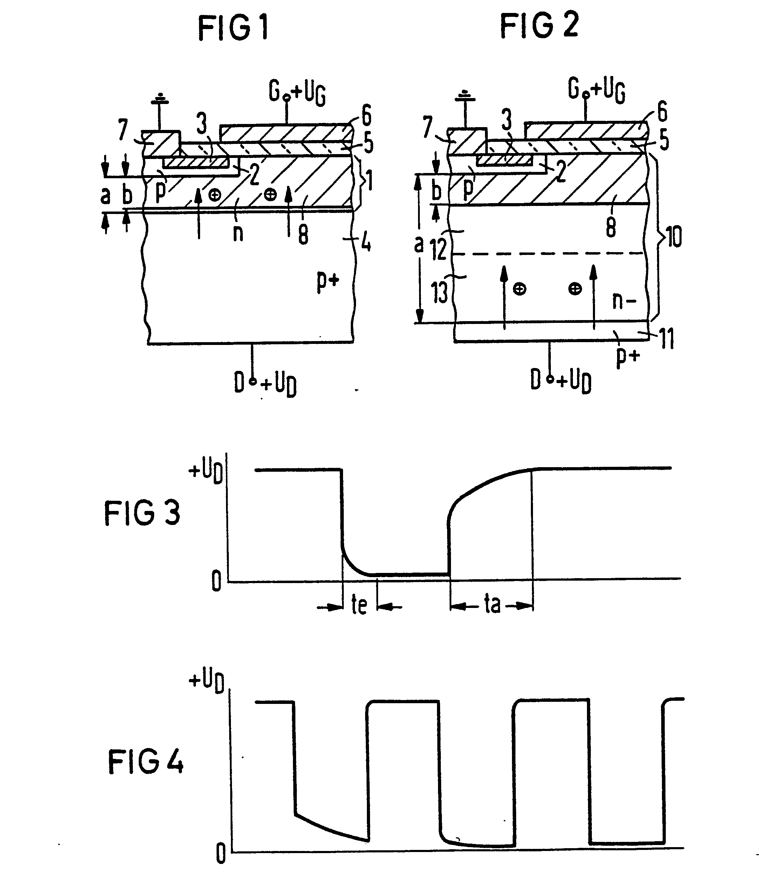

Das in Fig. 1 gezeigte bekannte Halbleiterbauelement hat einen Halbleiterkörper mit einer beispielsweise schwach n-dotierten ersten Zone 1. In die erste Oberfläche der Zone 1 ist eine zweite Zone 2 vom entgegengesetzten Leitungstyp planar eingebettet. Sie bildet die Kanalzone des Halbleiterbauelementes. In die zweite Zone 2 ist eine dritte Zone 3 vom ersten Leitungstyp ebenfalls planar eingebettet. Sie bildet die Sourcezone des Halbleiterbauelementes. Die genannte Oberfläche des Halbleiterkörpers ist mit einer Isolierschicht 5 wenigstens teilweise bedeckt. Auf dieser Isolierschicht 5 ist eine Gateelektrode 6 angeordnet, die den an die Oberfläche des Halbleiterkörpers tretenden Teil der Kanalzone 2 und den an die Oberfläche des Halbleiterkörpers tretenden Teil der ersten Zone 1 überdeckt. Zwischen der ersten Zone 1 und der anderen Oberfläche des Halbleiterkörpers liegt eine vierte Zone 4 vom zweiten Leitungstyp. Die Zonenfolge kann beginnend von der Sourcezone 3 charakterisiert werden durch n+ pn- p+. Die Zonen 2 und 3 sind durch einen Kontakt 7 kontaktiert. Dieser bildet einen starken Nebenschluß für die genannten Zonen.

Nach Anlegen einer Source-Drain-Spannung + $U_D$ an den Kontakt 7 kann das Halbleiterbauelement leitend gesteuert werden, wenn an die Gateelektrode G eine positive Gatespannung + $U_G$ angelegt wird. Der entstehende Kanal verbindet die Sourcezone 3 niederohmig mit der Drainzone 1.

2

Damit sinkt das Potential der Drainzone 1 und die Zone 4 emittiert positive Ladungsträger in die Drainzone 1. Die Zone 1 wird dadurch stark von Ladungsträgern beider Polarität überschwemmt, der Durchlaßwiderstand des Bauelementes ist somit gering.

Zum Abschalten des Halbleiterbauelementes wird die Gatespannung abgeschaltet. Damit hört der Fluß von negativen Ladungsträgern aus der Sourcezone 3 in die Zone 1 auf. Die in der Zone 1 gespeicherten Ladungsträger müssen jedoch aus der Zone 1 ausgeräumt werden. Die positiven Ladungsträger fließen weiter durch den pn-Übergang zwischen den Zonen 1 und 2 zum Kontakt 7, die negativen durch den pn-Übergang zwischen den Zonen 1 und 4. Gleichzeitig baut sich eine Raumladungszone 8 auf, die bei der Break-Down-Spannung den größten Teil der Zone 1 einnimmt. Hierbei ist der Abstand a zwischen der zweiten Zone 2 und der vierten Zone 4 etwa gleich der Dicke b der Raumladungszone 8.

Während des Ausräumens emittiert die Zone 4 weiterhin Löcher in die Zone 1. Dies führt zu der in Fig. 3 dargestellten Ausschaltverzögerung $t_a$. Die Einschaltverzögerung $t_e$ ist dagegen relativ klein, da die aus der Zone 4 stammenden positiven Ladungsträger beim Einschalten schnell eine hohe Konzentration erreichen.

Das Halbleiterbauelement gemäß der Erfindung hat gegenüber dem nach Fig. 1 eine wesentlich dickere schwachdotierte Mittelzone 10. Diese Mittelzone ist mindestens zweimal dicker als die größte Ausdehnung b der Raumentladungszone 8, gemessen vom pn-Übergang zwischen den Zonen 2 und 10. Der Abstand a ist dabei zweckmäßigerweise 2 bis 10 mal so groß wie der Abstand b. Die größte Breite b der Raumladungszone 8 kann nach bekannten Beziehungen, wie sie z. B. im deutschen Patent 1 250 561 für abrupte pn-Übergänge angegeben sind, ausgedrückt werden zu

$$b = \varepsilon_o\, \varepsilon_r\, \mu\, E_k\, \rho$$

wenn $\varepsilon_o$ die absolute Dielektrizitätskonstante, $\varepsilon_r$ die relative Dielektrizitätskonstante des Halbleitermaterials, $\mu$ die Beweglichkeit der Majoritätsladungsträger in der Zone 10, $E_k$ die kritische Feldstärke im Halbleitermaterial und $\rho$ der spezifische Widerstand in der Zone 10 ist. Durch diese Beziehung wird angegeben, wie weit sich die Raumladungszone bei Anlegen einer Sperrspannung ausdehnt, wenn eine Spannung am Halbleiterkörper liegt, die der Break-Down-Spannung $U_{BD}$ entspricht. Da die Dicke a der Zone 10 mindestens zweimal größer als die größte Ausdehnung der Raumladungszone bei anliegender Spannung $U_{BD}$ sein soll, gilt, daß der Abstand a zwischen der zweiten Zone 2 und der vierten Zone 4 in cm

$$a \geqslant 2\, \varepsilon_o\, \varepsilon_r\, \mu\, E_k\, \rho$$

sein muß. Wird diese Bedingung eingehalten, so gelangt auch bei diffundierten pn-Übergängen nur noch ein geringer Bruchteil der positiven Ladungsträger zur Sourcezone.

Beim Einschalten des Halbleiterbauelementes fließen wie oben beschrieben, negative Ladungsträger aus der Sourcezone 3 in die Drainzone 10 und rufen eine Emission von positiven Ladungsträgern aus der vierten Zone 11 hervor. Die positiven Ladungsträger diffundieren zur Kanalzone 2 und werden dort gesammelt. Die Mittelzone wird durch Ladungsträger überschwemmt, das Halbleiterbauelement wird eingeschaltet. Sein Durchlaßwiderstand ist sehr gering, da die Zone 10 nun eine hohe Leitfähigkeit hat.

Beim Ausschalten wird der Kanal an der Oberfläche der Kanalzone 2 sehr schnell gesperrt, wodurch der Elektronenstrom abrupt aufhört. Die aus der Zone 11 stammenden positiven Ladungsträger können nun wegen der großen Dicke der Zone 10 nur noch zum geringen Teil bis zur Raumladungszone 8 diffundieren, da die Entfernung zwischen der Zone 11 und der Raumladungszone 8 wesentlich größer als ihre Diffusionslänge ist. Die Entfernung a zwischen den Zonen 2 und 4 ist dabei zweckmäßigerweise zwei bis zehnmal so groß, wie die Diffusionslänge der positiven Ladungsträger in der Zone 10. Es empfiehlt sich, die Relation a : b nicht größer als 10 zu wählen, da sonst die Duchlaßspannung zu groß wird.

Beim Aufbau der Raumladungszone wird nun nur der in der Raumladungszone gespeicherte Teil an positiven Ladungsträgern abgesaugt. Da dieser Anteil jedoch klein gegenüber der Gesamtmenge der gespeicherten Minoritätsladungsträger ist, kommt es zu keiner merklichen Verzögerung des Ausschaltens. Dies ist in Fig. 4 dargestellt. Nachteilig ist eine gewisse Einschaltverzögerung, die durch den relativ langen Weg bedingt ist, den die Minoritätsladungsträger ausgehend von der Zone 11 zurückzulegen haben. Dieser Nachteil ist jedoch dann nicht von Bedeutung, wenn das Halbleiterbauelement im periodisch getakteten Betrieb eingesetzt wird. In Fig. 4 ist gezeigt, daß die Einschaltverzögerung bei jedem Impuls abnimmt und im stationären Zustand nur noch sehr gering ist.

Die Drainzone 10 kann über ihre Dicke konstant dotiert sein. Sie kann jedoch auch, wie in Fig. 2 anhand der waagrechten gestrichelten Linie dargestellt ist, aus zwei Schichten 12 und 13 bestehen, die unterschiedlich hoch dotiert sind. Dabei ist die Schicht 13, die an die Zone 11 angrenzt, höher dotiert und die zwischen Zone 13 und der zweiten Zone 2 liegende Schicht 12 schwächer dotiert. Dies hat den Vorteil, daß der Bahnwiderstand bei Beginn des Einschaltvorgangs geringer ist und der Strom von positiven Ladungsträgern stärker einsetzen kann. Die Schicht 12 kann beispielsweise einen spezifischen Widerstand von 50 Ohm cm aufweisen und 60 μm dick sein, die entsprechenden Werte der Schicht 13 sind 1 bis 5 Ohm cm und 60 bis 25 μm.

Ein Halbleiterbauelement für 1000 V Sperrspannung kann beispielsweise eine gesamte Dicke des Halbleiterkörpers von 0,5 mm haben. Der Anteil der Zone 11 beträgt dabei beispielsweise 5 μm. Der spezifische Widerstand der Zone 10 kann 50 Ohm cm betragen. Die Zone 2 wird beispielsweise durch Ionenimplantation hergestellt und hat eine Dicke von ca. 1 - 3 μm. Mit einer solchen Dimensionierung wurde eine Ausschaltverzögerung $t_a$ von < 0,5 μsec gemessen.

## Patentansprüche

1. Durch Feldeffekt steuerbares Halbleiterbauelement mit einem Halbleiterkörper mit den Merkmalen:

a) der Halbleiterkörper enthält eine Drainzone (10) vom ersten Leitungstyp,

b) die Drainzone (10) grenzt an eine der Oberflächen des Halbleiterkörpers, die zumindest teilweise mit einer Isolierschicht (5) bedeckt ist,

c) in die Drainzone (10) ist eine Kanalzone (2) vom zweiten Leitungstyp planar eingebettet,

d) in die Kanalzone (2) ist eine Sourcezone (3) vom ersten Leitungstyp planar eingebettet,

e) die Kanalzone (2) und die Sourcezone (3) sind durch einen Nebenschluß (7) elektrisch miteinander verbunden,

f) an der anderen Oberfläche des Halbleiterkörpers ist eine am die Drainzone (10) grenzende vierte Zone (11) vom zweiten Leitungstyp vorgesehen,

g) die Drainzone (10) ist schwach dotiert im Vergleich zu den anderen Zonen (2, 3, 11),

h) auf der Isolierschicht (5) ist eine Gateelektrode (6) angeordnet, die den an die Oberfläche des Halbleiterkörpers tretenden Teil der Kanalzone (2) überdeckt,

gekennzeichnet, durch die Merkmale:

i) der Abstand (a) zwischen Kanalzone (2) und vierter Zone (11) ist mindestens doppelt so groß wie die Diffusionslänge der Minoritätsladungsträger in der Drainzone (10) und

k) der Abstand (a) zwischen Kanalzone und vierter Zone genügt der Bedingung:

$$a \geqslant 2\, \varepsilon_o\, \varepsilon_r\, \mu\, E_k\, \rho,$$

wenn $\varepsilon_o$ die absolute Dielektrizitätskonstante, $\varepsilon_r$ die relative Dielektrizitätskonstante des Halbleitermaterials, μ die Beweglichkeit der Majoritätsladungsträger in der ersten Zone, $E_k$ die kritische elektrische Feldstärke des Halbleitermaterials ist und ρ der spezifische Widerstand der Drainzone (10) ist.

2. Halbleiterbauelement nach Anspruch 1, dadurch gekennzeichnet, daß der Abstand

$$a \geqslant 10\, \varepsilon_o\, \varepsilon_r\, \mu\, E_k\, \rho\ \text{ist}.$$

3. Halbleiterbauelement nach Anspruch 1 oder 2, dadurch gekennzeichnet, daß die Drainzone (10) aus zwei unterschiedlich stark dotierten Schichten (12, 13) gleichen Leitungstyps besteht und daß die höher dotierte Schicht (13) an die vierte Zone (11) angrenzt.

4. Verwendung des Halbleiterbauelements nach einem der Ansprüche 1 bis 3 als periodisch getakteter Schalter.

## Claims

1. Field-effect-controlled semiconductor component containing a semiconductor body having the features:

a) the semiconductor body incorporates a drain zone (10) of the first conduction type,

b) the drain zone (10) is adjacent to one of the surfaces of the semiconductor body, which surface is at least partially coated with an insulating layer (5),

c) a channel zone (2) of the second conduction type is embedded in a planar configuration in the drain zone (10),

d) a source zone (3) of the first conduction type is embedded in a planar configuration in the channel zone (2),

e) the channel zone (2) and the source zone (3) are electrically connected to each other by a shunt (7),

f) a fourth zone (11) of the second conduction type, which is adjacent to the drain zone (10), is provided at the other surface of the semiconductor body,

g) the drain zone (10) is lightly doped compared with the other zones (2, 3, 11),

h) a gate electrode (6) which covers the part of the channel zone (2) emerging at the surface of the semiconductor body is disposed on the insulating layer (5),

characterised by the features:

i) the distance (a) between channel zone (2) and fourth zone (11) is at least twice as large as the diffusion length of the minority charge carriers in the drain zone (10), and

k) the distance (a) between channel zone and fourth zone satisfies the condition:

$$a \geqslant 2\, \varepsilon_o\, \varepsilon_r\, \mu\, E_k\, \rho,$$

if $\varepsilon_o$ is the absolute permittivity, $\varepsilon_r$ is the relative permittivity of the semiconductor material, μ is the mobility of the majority charge carriers in the first zone, $E_k$ is the critical electric field strength of the semiconductor material, and ρ is the specific resistance of the drain zone (10).

2. Semiconductor component according to Claim 1, characterised in that the distance is:

$$a \geqslant 10\, \varepsilon_o\, \varepsilon_r\, \mu\, E_k\, \rho.$$

3. Semiconductor component according to Claim 1 or 2, characterised in that the drain zone (10) comprises two variously heavily doped layers (12, 13) of the same conduction type and that the more highly doped layer (13) is adjacent to the fourth zone (11).

4. Use of the semiconductor component according to one of the Claims 1 to 3 as a periodically operated switch.

**Revendications**

1. Composant à semiconducteurs susceptible d'être commandé par effet de champ et comportant un corps semiconducteur présentant les caractéristiques suivantes:

a) le corps semiconducteur contient une zone de drain (10) possédant un premier type de conductivité,

b) la zone de drain (10) jouxte l'une des surface du corps semiconducteur, qui est recouverte au moins partiellement par une couche isolante (5),

c) une zone de canal (2) possédant un second type de conductivité est insérée, selon une configuration planar, dans la zone de drain (10),

d) une zone de source (3) possédant le premier type de conductivité est insérée, selon une configuration planar, dans la zone de canal (2),

e) la zone de canal (2) et la zone de source (3) sont reliées électriquement entre elles par une dérivation (7),

f) une quatrième zone (11) possédant le second type de conductivité, qui jouxte la zone de drain (10), est prévue sur l'autre surface du corps semiconducteur,

g) la zone de drain (10) est faiblement dopée par rapport aux autre zones (2, 3, 11),

h) sur la couche isolante (5) se trouve disposée une électrode de grille (6), qui recouvre la partie, qui apparaît au niveau de la surface du corps semiconducteur, de la zone de canal (2),

caractérisé par les particularités suivantes:

i) la distance (a) entre la zone de canal (2) et la quatrième zone (11) est égale au moins au double de la longueur de diffusion des porteurs de charges minoritaires dans la zone de drain (10), et

k) la distance (a) entre la zone de canal et la quatrième zone satisfait à la relation

$$a \geqslant 2\, \varepsilon_o\, \varepsilon_r\, \mu\, E_k\, \rho,$$

$\varepsilon_o$ désignant la constante diélectrique absolue, $\varepsilon_r$ la constante diélectrique relative du matériau semiconducteur, $\mu$ la mobilité des porteurs de charges majoritaires dans la première zone, $E_k$ l'intensité de champ électrique du matériau semiconducteur et $\rho$ la résistance spécifique de la zone de drain (10).

2. Composant à semiconducteurs suivant la revendication 1, caractérisé par le fait que la distance est telle que l'on a

$$a \geqslant 10\, \varepsilon_o\, \varepsilon_r\, \mu\, E_k\, \rho.$$

3. Composant à semiconducteurs suivant la revendication 1 ou 2, caractérisé par le fait que la zone de drain (10) est constituée par deux couches (12, 13) possédant le même type de conductivité et dopées avec des dopages différents, et que la couche (13) la plus fortement dopée jouxte la quatrième zone (11).

4. Utilisation du composant à semiconducteurs suivant l'une des revendications 1 à 3 en tant qu'interrupteur commandé de façon périodique.

## FIG 1

## FIG 2

## FIG 3

## FIG 4